# EUROPEAN PATENT SPECIFICATION

(11) **EP 0 655 652 B1**
(45) Date of publication and mention of the grant of the patent: **17.02.1999**
(21) Application number: 94202989.3
(22) Date of filing: 14.10.1994
(51) Int. Cl.: G03F 7/07, B41N 3/08

(54) **A method for lithographic printing using a plate prepared according to the silver salt diffusion transfer process and a dampening solution**
Lithographisches Druckverfahren unter Verwendung einer mittels Silbersalz-Diffusionsübertragung hergestellten Druckform und Feuchtwasser hierfür
Procédé pour l'impression lithographique utilisant une plaque préparée par le procédé de diffusion-transfert de sel d'argent et une solution de mouillage

(30) Priority: 29.11.1993 EP 93203327
(43) Date of publication of application: 31.05.1995
(73) Proprietor: AGFA-GEVAERT N.V., 2640 Mortsel (BE)
(72) Inventor: Van Rompuy, Ludo, c/o Agfa-Gevaert N.V., B-2640 Mortsel (BE)

(56) References cited:
- EP-A- 0 223 881
- EP-A- 0 304 662
- EP-A- 0 535 678
- EP-A- 0 554 585
- GB-A- 1 398 041
- GB-A- 2 081 183
- US-A- 3 829 319
- US-A- 4 220 702

## Description

### 1. Field of the invention.

The present invention relates to a method for printing by using dampening solutions and lithographic printing plates obtained according to the silver salt diffusion transfer process. Furthermore the present invention relates to the use of said dampening solutions with said lithographic printing plates.

### 2. Background of the invention.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background. For example, typical lithographic printing plates are disclosed e.g. EP-A-423399 and EP-A-410500.

The DTR-image can be formed in the image-receiving layer of a sheet or web material which is a separate element with respect to the photographic silver halide emulsion material (a so-called two-sheet DTR-element) or in the image-receiving layer of a so-called single-support element, also called mono-sheet element, which contains at least one photographic silver halide emulsion layer integral with an image-receiving layer in waterpermeable relationship therewith. It is the latter mono-sheet version which is preferred for the preparation of offset printing plates by the DTR method.

According to the preferred embodiment of the mono-sheet DTR-offset printing plate, disclosed in e.g. US-P-4,722,535 and GB-P-1,241,661, a flexible support e.g. of paper or of an organic resin is provided in the order given with a silver halide emulsion layer and a layer containing physical development nuclei serving as the image-receiving layer. After information-wise exposure and development the imaged element is used as a printing plate without the removal of the now-useless emulsion layers.

Said type of mono-sheet DTR offset printing plates is not compatible with other types of printing plates with regard to dampening solutions and printing inks, which is cumbersome for the printer. In order that said mono-sheet DTR offset printing plates show no ink acceptance in the non-printing areas (no staining), use should be made of special printing inks and dampening solutions containing a seizable amount of a transparent pigment, usually colloidal siliciumoxide as disclosed e.g. in US-P 3.829.319, US-P 4.238.279 and EP-A 304.662.

In recent years meso-ionic compounds, already well known in silver halide photography and used in the fixing step of a photographic process as disclosed in EP-A-431568, for increasing temperature latitude as disclosed in JP-A-60-117240, for reducing fog as disclosed in US-P-4,615,970, in preparing silver halide emulsions as disclosed in US-P-4,631,253, in bleach etching baths as disclosed in EP-A-321839, to prevent pressure marks as disclosed in US-P-4,624,913 and in a developer or a prebath for development acceleration as disclosed in EP-A-533182, are also used in the preparation of a lithographic printing plate according to the DTR process for increasing the printing endurance and ink acceptance as disclosed in JP-Pi 04-324.448, JP-Pi 04-328.559, EP-A-535678 and EP-A-544585.

It is still desired that said mono-sheet DTR offset printing plates should be improved with regard to printing qualities e.g. have a better ink acceptance in the printing areas, less staining, less toning (i.e. less copies that have to be disposed off because of ink acceptance in the non-printing areas during start-up of the printing process) and a higher printing endurance.

### 3. Summary of the invention.

It is an object of the present invention to provide a method for lithographic printing using a dampening solution and a lithographic printing plate obtained according to the DTR-process showing good printing properties i.e. good ink acceptance in the printing areas, no ink acceptance in the non-printing areas and a high printing endurance.

Further objects of the present invention will become clear from the description hereinafter.

According to the present invention there is provided a method for lithographic printing comprising the following steps:
- preparing a lithographic printing plate according to the silver salt diffusion transfer process by (1) image-wise exposing an imaging element comprising on a support a photosensitive layer comprising a silver halide emulsion and an image receiving layer containing physical development nuclei and (2) developing said imaging element in the presence of developing agent(s) and silver halide solvent(s) using an alkaline processing liquid,
- mounting said lithographic printing plate to a lithographic printing press, and
- printing while supplying to said lithographic printing plate a dampening solution and a printing ink
characterized in that (a) said development of the exposed imaging element is carried out in the presence of a meso-ionic compound and (b) the dampening solution is substantially free of a transparent pigment with an average grain diameter of less than 0.1 µm.

### 4. Detailed description of the invention.

According to the present invention it has been found that a method for lithographic printing using a lithographic printing plate obtained according to the DTR-process in the presence of a meso-ionic compound and a dampening solution substantially free of a transparent pigment with an average grain diameter of less than 0.1 µm shows good printing properties i.e. good ink acceptance in the printing areas, no ink acceptance in the non-printing areas and a high printing endurance.

Meso-ionic compounds as referred to in the present invention are a group of compounds defined by W. Baker and W.D. Ollis as "5- or 6-membered heterocyclic compounds which cannot be represented satisfactorily by any one covalent or polar structure and possess a sextet of π-electrons in association with the atoms composing the ring. The ring bears a fractional positive charge balanced by a corresponding negative charge located on a covalently attached atom or group of atoms" as described in Quart. Rev., Vol. 11, p. 15 (1957) and Advances in Heterocyclic Chemistry, Vol. 19, P. 4 (1976).

Preferred meso-ionic compounds for use in accordance with the present invention are triazolium thiolates and more preferably 1,2,4-triazolium-3-thiolates and most preferably those that correspond to the following formula: 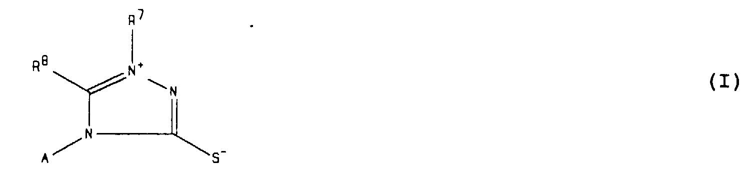 wherein R⁷ and R⁸ each independently represents an alkyl group, alkenyl group, cycloalkyl group, aralkyl group, aryl group or heterocyclic group, which groups can be substituted; A represents an alkyl group, alkenyl group, cycloalkyl group, aralkyl group, aryl group, heterocyclic group, which groups can be substituted or -NR⁹R¹⁰ wherein R⁹ and R¹⁰ each independently represents hydrogen, an alkyl group or aryl group, which groups can be substituted, or R⁷ and R⁸ or R⁸ and A or R⁹ and R¹⁰ represent the necessary atoms to form a 5- or 6-membered ring.

Specific examples of 1,2,4-triazolium-3-thiolates suitable for use in accordance with the present invention are shown in table 1.

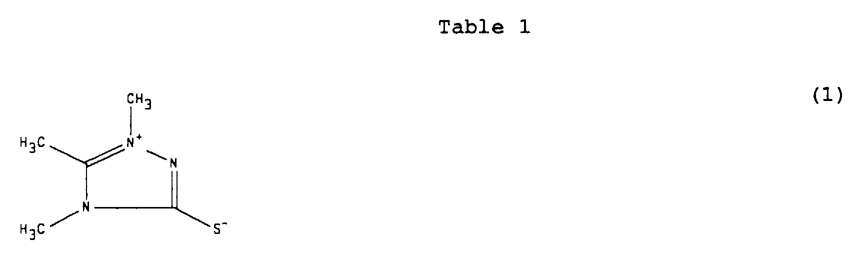

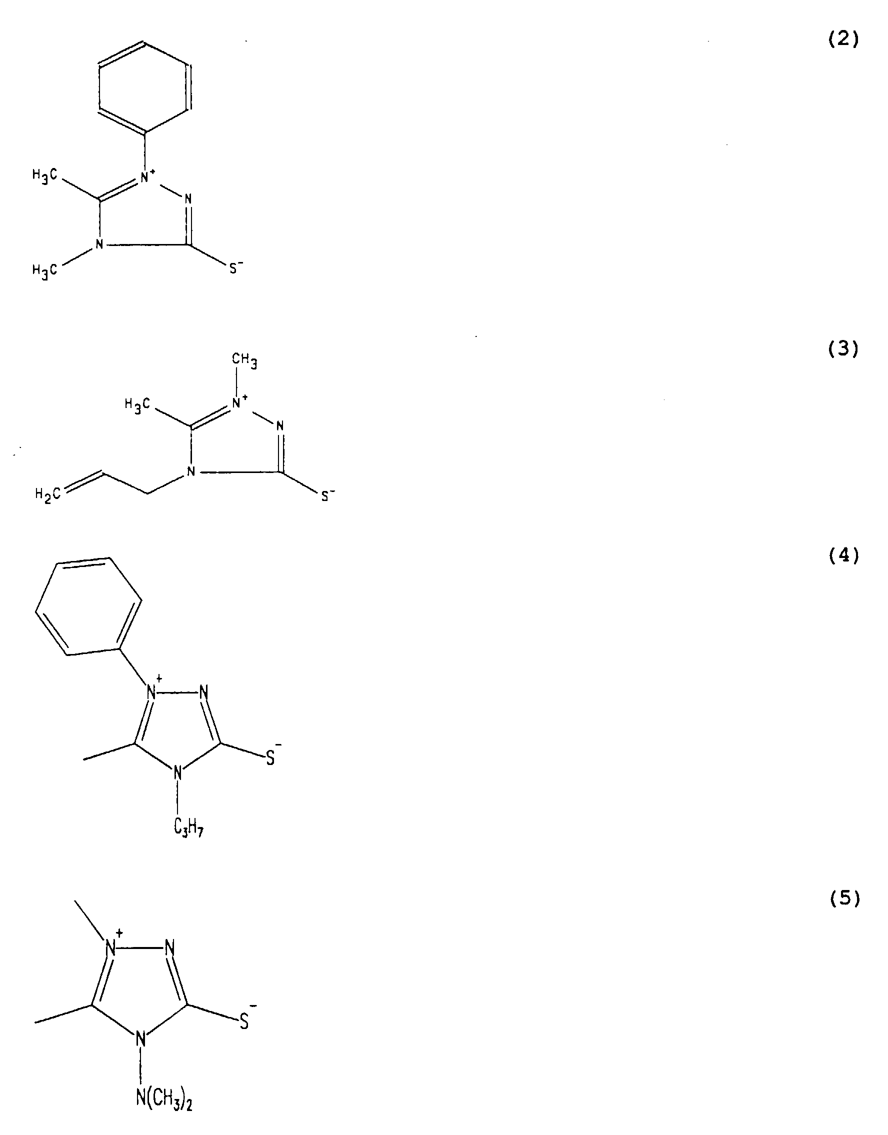

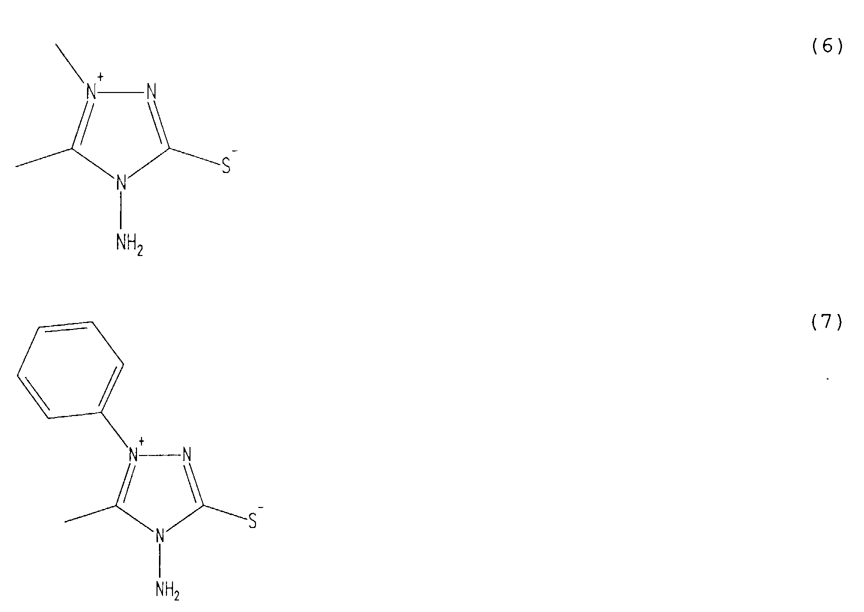

According to the preferred embodiment of the present invention at least part and most preferably all of the meso-ionic compound is present in the alkaline processing liquid used for developing the image-wise exposed imaging element. Preferably the amount of meso-ionic compound in the alkaline processing liquid is between 0.1 mmol/l and 50 mmol/l and more preferably between 0.5 mmol/l and 10 mmol/l and most preferably between 1 mmol/l and 5 mmol/l.

However the meso-ionic compound may be incorporated in one or more layers comprised on the support of the imaging element as disclosed in EP-A 554585.

Dampening solutions according to the present invention are dampening solution substantially free of a transparent pigment with an average grain diameter of less than 0.1 µm.

In general, said transparent pigment is a non-water swellable, inorganic fine particle with an average grain diameter of less than 0.05 µm, especially a sol of oxide or hydroxide of a metal belonging to Group III-IV of the periodic table such as colloidal siliciumdioxide and colloidal alumina.

A photographic material for use in connection with the method of the present invention comprises on a support in the order given a silver halide emulsion layer and a layer containing physical development nuclei.

Supports suitable for use in accordance with the present invention may be opaque or transparent, e.g. a paper support or resin support. When a paper support is used preference is given to one coated at one or both sides with an Alpha-olefin polymer. It is also possible to use an organic resin support e.g. poly(ethylene terephthalate) film or poly-Alpha-olefin films. The thickness of such organic resin film is preferably comprised between 0.07 and 0.35 mm. These organic resin supports are preferably coated with a hydrophilic adhesion layer which can contain water insoluble particles such as silica or titanium dioxide.

The image receiving layer containing physical development nuclei is preferably free of hydrophilic binder but may comprise small amounts upto 30% by weight of the total weight of said layer of a hydrophilic colloid e.g. polyvinyl alcohol to improve the hydrophilicity of the surface. Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are salts such as e.g. selenides, polyselenides, polysulphides, mercaptans, and tin (II) halides. Heavy metals, preferably silver, gold, platinum, palladium, and mercury can be used in colloidal form.

The photosensitive layer used according to the present invention may be any layer comprising a hydrophilic colloid binder and at least one silver halide emulsion, at least one of the silver halide emulsions being photosensitive.

The photographic silver halide emulsion(s) used in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

For use according to the present invention the silver halide emulsion or emulsions preferably consist principally of silver chloride while a fraction of silver bromide may be present ranging from 1 mole % to 40 mole %. Most preferably a silver halide emulsion containing at least 70 mole% of silver chloride is used.

The average size of the silver halide grains may range from 0.10 to 0.70 µm , preferably from 0.25 to 0.45 µm.

Preferably during the precipitation stage iridium and/or rhodium containing compounds or a mixture of both are added. The concentration of these added compounds ranges from 10⁻⁸ to 10⁻³ mole per mole of AgNO₃, preferably between 10⁻⁷ and 10⁻⁶ mole per mole of AgNO₃.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

Apart from negative-working silver halide emulsions that are preferred for their high photosensitivity, use can be made also of direct-positive silver halide emulsions that produce a positive silver image in the emulsion layer(s) and a negative image on the aluminium foil.

Suitable direct positive silver halide emulsions for use in accordance with the present invention are silver halide emulsions that have been previously fogged or that mainly form an internal latent image as referred to hereinbefore.

Internal latent image-type silver halide emulsions that can be used in accordance with the present invention have been described in e.g. US-A 2,592,250, 3,206,313, 3,271,157, 3,447,927, 3,511,662, 3,737,313, 3,761,276, GB-A 1,027,146, and JA Patent Publication No. 34,213/77. However, the silver halide emulsions used in the present invention are not limited to the silver halide emulsions described in these documents.

The other type of direct positive type silver halide emulsions for use in accordance with the present invention, which is of the previously fogged type, may be prepared by overall exposing a silver halide emulsion to light and/or by chemically fogging a silver halide emulsion. Chemical fog specks may be formed by various methods for chemical sensitization.

Chemical fogging may be carried out by reduction or by a compound which is more electropositive than silver e.g. gold salts, platinum salts, iridium salts etc., or a combination of both. Reduction fogging of the silver halide grains may occur by high pH and/or low pAg silver halide precipitation or digestion conditions e.g. as described by Wood J. Phot. Sci. 1 (1953), 163 or by treatment with reducing agents e.g. tin(II) salts which include tin(II)chloride, tin complexes and tin chelates of (poly)amino(poly)carboxilic acid type as described in British Patent 1,209,050 , formaldehyde, hydrazine, hydroxylamine, sulphur compounds e.g. thiourea dioxide, phosphonium salts e.g. tetra(hydroxymethyl)-phosphonium chloride, polyamines e.g. diethylenetriamine, bis(p-aminoethyl)sulphide and its water-soluble salts, hydrazine derivatives, alkali arsenite, amine borane etc. or mixtures thereof.

When fogging of the silver halide grains occurs by means of a reducing agent e.g. thiourea dioxide and a compound of a metal more electropositive than silver especially a gold compound, the reducing agent is preferably used initially and the gold compound subsequently. However, the reverse order can be used or both compounds can be used simultaneously.

In addition to the above described methods of chemically fogging chemical fogging can be attained by using said fogging agents in combination with a sulphur-containing sensitizer, e.g. sodium thiosulphate or a thiocyanic acid compound e.g. potassium thiocyanate.

The silver halide emulsions of the DTR-element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons.

The spectral photosensitivity of the silver halide can also be adjusted for exposure by laser light e.g. helium-neon laser light, argon laser light, and solid state laser light. Dyes that can be used for adjusting the photosensitivity to laser light have been disclosed i.a. in the documents cited in EP-A-93200339.5 and US-P-5,200,294.

The silver halide emulsions may contain the usual emulsion stabilizers. Suitable emulsion stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable emulsion stabilizers are i.a. heterocyclic mercapto compounds.

The silver halide emulsions may contain pH controlling ingredients. Preferably the emulsion layer is coated at a pH value below the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217.

More details about the composition, preparation and coating of silver halide emulsions suitable for use in accordance with the present invention can be found in e.g. Product Licensing Index, Vol. 92, December 1971, publication 9232, p. 107-109.

In addition to the above described emulsion layer and image receiving layer other hydrophilic colloid layers in water permeable relationship with these layers may be present. For example it is especially advantageous to include a base-layer between the support and the photosensitive silver halide emulsion layer. In a preferred embodiment of the present invention said base-layer serves as an antihalation layer. On the other hand, in order to gain sensitivity, light reflecting pigments, e.g. titaniumdioxide can be present. Further this layer can contain hardening agents, matting agents, e.g. silica particles, and wetting agents. At least part of these matting agents and/or light reflection pigments may also be present in the silver halide emulsion layer the most part however preferably being present in said base-layer. As a further alternative the light reflecting pigments may be present in a separate layer provided between the antihalation layer and the photosensitive silver halide emulsion layer.

In a preferred embodiment in connection with the present invention a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a double layer pack.

The hydrophilic layers usually contain gelatin as hydrophilic colloid binder. Mixtures of different gelatins with different viscosities can be used to adjust the rheological properties of the layer. Like the emulsion layer the other hydrophilic layers are coated preferably at a pH value below the isoelectric point of the gelatin. But instead of or together with gelatin, use can be made of one or more other natural and/or synthetic hydrophilic colloids.

The hydrophilic layers of the photographic element, especially when the binder used is gelatin, can be hardened with the known appropriate hardening agents. Preferably used hardening agents are of the aldehyde type. The hardening agents can be used in wide concentration range but are preferably used in an amount of 4% to 7% of the hydrophilic colloid.

The imaging element used according to the present invention may further comprise various kinds of surface-active agents in the photographic emulsion layer or in at least one other hydrophilic colloid layer. Suitable surface-active agents include non-ionic agents, anionic agents comprising an acid group, ampholytic agents and cationic agents. Preferably compounds containing perfluorinated alkyl groups are used.

The photographic material of the present invention may further comprise various other additives such as e.g. compounds improving the dimensional stability of the photographic element, UV-absorbers, spacing agents and plasticizers.

A wide choice of cameras for exposing the photosensitive silver halide emulsion exists on the market. Horizontal, vertical and darkroom type cameras and contact-exposure apparatus are available to suit any particular class of reprographic work. The imaging element can also be exposed in accordance with the present invention with the aid of i.a. laser recorders and cathode ray tubes.

As mentioned above, the development and diffusion transfer are effected with the aid of an aqueous alkaline solution in the presence of (a) developing agent(s) and (a) silver halide solvent(s).

Preferably, the alkaline processing solution contains as silver halide solvent in addition to the above mentioned meso-ionic compound an alkanolamine. Alkanolamines that are suitable for use in accordance with the present invention may be of the tertiary, secundary or primary type. Examples of alkanolamines that may be used in connection with the present invention correspond to the following formula: 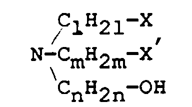 wherein X and X' independently represent hydrogen, a hydroxyl group or an amino group, 1 and m represent 0 or integers of 1 or more and n represents an integer of 1 or more. Preferably used alkanolamines are e.g. N-(2-aminoethyl)ethanolamine, diethanolamine, N-methylethanolamine, triethanolamine, N-ethyldiethanolamine, diisopropanolamine, ethanolamine, 4-aminobutanol, N,N-dimethylethanolamine, 3-aminopropanol, N,N-ethyl-2,2'-iminodiethanol etc. or mixtures thereof.

The alkanolamines are preferably used in a concentration of 0.05% to 10% by weight and more preferably in a concentration of 0.05% by weight to 7% by weight.

In addition to the meso-ionic compound according to the present invention and optionally an alkanolamine the alkaline processing liquid can comprise still further silver halide solvents. Additional silver halide solvents for use in connection with the present invention are e.g. 2-mercaptobenzoic acid, cyclic imides, oxazolidones, thiocyanates, thioethers and thiosulfates.

Preferably used thioethers correspond to the following general formula:

Z-(R¹-S)ₜ-R²-S-R³-Y

wherein Z and Y each independently represents hydrogen, an alkyl group, an amino group, an ammonium group, a hydroxyl, a sulfo group, a carboxyl, an aminocarbonyl or an aminosulfonyl, R¹, R² and R³ each independently represents an alkylene that may be substituted and optionally contain an oxygen bridge and t represents an integer from 0 to 10. Examples of thioether compounds corresponding to the above formula are disclosed in e.g. US-P-4,960,683 and EP-A 547,662, which therefor are incorporated herein by reference.

Preferably the silver halide solvent is used in an amount between 0.05% by weight and 10% by weight and more preferably between 0.05% by weight and 7% by weight.

The alkaline processing liquid used in accordance with the present invention preferably has a pH between 9 and 14 and more preferably between 10 and 13. Said pH may be established by an organic or inorganic alkaline substance or a combination thereof. Suitable inorganic alkaline substances are e.g. potassium or sodium hydroxide, carbonate, phosphate. Suitable organic alkaline substances are e.g. alkanolamines. In the latter case the alkanolamines will provide or help maintain the pH and serve as a silver halide complexing agent. The present invention allows the use of alkaline processing liquids of low pH (11 or less) to be used. This is a further advantage of the present invention because such liquids are less corrosive and less susceptible to exhaustion.

The alkaline processing liquid may also contain (a) developing agent(s). In this case the alkaline processing liquid is called a developer. On the other hand some or all of the developing agent(s) may be present in one or more layers of the photographic material or imaging element. When all of the developing agents are contained in the imaging element the alkaline processing liquid is called an activator or activating liquid.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are the 1-phenyl-3-pyrazolidinones. Even more preferred, particularly when they are incorporated into the photographic material are 1-phenyl-3-pyrazolidinones of which the aqueous Solubility is increased by a hydrophilic substituent such as e.g. hydroxy, amino, carboxylic acid group, sulphonic acid group etc.. Examples of 1-phenyl-3-pyrazolidinones subsituted with one or more hydrophilic groups are e.g. 1-phenyl-4,4-dimethyl-2-hydroxy-3-pyrazolidone, 1-(4-carboxyphenyl)-4,4-dimethyl-3-pyrazolidone etc.. However other developing agents can be used.

At least the auxiliary developing agents are preferably incorporated into the photographic material, preferably in the silver halide emulsion layer of the photographic material, in an amount of less than 150mg/g of silver halide expressed as AgNO₃, more preferably in an amount of less than 100mg/g of silver halide expressed as AgNO₃.

According to the present invention the alkaline processing liquid preferably also contains hydrophobizing agents for improving the hydrophobicity of the silver image obtained in the image receiving layer. The hydrophobizing agents used in connection with the present invention are compounds that are capable of reacting with silver or silver ions and that are hydrophobic i.e. insoluble in water or only slightly soluble in water. Generally these compounds contain a mercapto group or thiolate group and one or more hydrophobic substituents e.g. an alkyl group containing at least 3 carbon atoms. Examples of hydrophobizing agents for use in accordance with the present invention are e.g. those described in US-P 3,776,728, and US-P 4,563,410. Preferred compounds correspond to one of the following formulas: 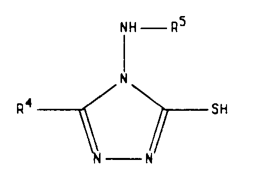 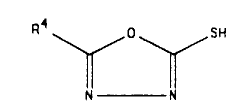 wherein R⁵ represents hydrogen or an acyl group, R⁴ represents alkyl, aryl or aralkyl. Most preferably used compounds are compounds according to one of the above formulas wherein R⁴ represents an alkyl containing 3 to 16 C-atoms.

According to the present invention the hydrophobizing agents are contained in the alkaline processing liquid in an amount of at least 0.1g/l, more preferably at least 0.2g/l and most preferably at least 0.3g/l. The maximum amount of hydrophobizing agents will be determined by the type of hydrophobizing agent, type and amount of silver halide solvents. Typically the concentration of hydrophobizing agent is preferably not more than 1.5g/l and more preferably not more than lg/l.

The alkaline processing liquid preferably also contains a preserving agent having antioxidation activity, e.g. sulphite ions provided e.g. by sodium or potassium sulphite. For example, the aqueous alkaline solution comprises sodium sulphite in an amount ranging from 0.15 to 1.0 mol/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners. In accordance with the present invention it is furthermore preferred to use a spreading agent or surfactant in the alkaline processing liquid to assure equal spreading of the alkaline processing liquid over the surface of the photographic material. Such a surfactant should be stable at the pH of the alkaline processing liquid and should assure a fast overall wetting of the surface of the photographic material. A surfactant suitable for such purpose is e.g. a fluor containing surfactant such as e.g. C₇F₁₅COONH₄. It is furthermore advantageous to add glycerine to the alkaline processing liquid so as to prevent crystallization of dissolved components of said alkaline processing liquid.

Development acceleration can be accomplished by addition of various compounds to the alkaline processing liquid and/or one or more layers of the photographic element, preferably polyalkylene derivatives having a molecular weight of at least 400 such as those described in e.g. US-P 3,038,805 - 4,038,075 - 4,292,400 - 4,975,354.

Subsequent to the development in an alkaline processing liquid in accordance with the present invention the surface of the printing plate is preferably neutralized using a neutralization liquid.

A neutralization liquid generally has a pH between 5 and 7. The neutralization liquid preferably contains a buffer e.g. a phosphate buffer, a citrate buffer or mixture thereof. The neutralization solution can further contain bactericides, substances which influence the hydrophobic / hydrophilic balance of the Printing plate obtained after processing of the DTR element, e.g. Silica and wetting agents, preferably compounds containing perfluorinated alkyl groups.

In accordance with the present invention in a following step the lithographic plate is mounted on a lithographic press and treated with a dampening solution containing less than 1 g/l of a transparent pigment with an average grain diameter of less than 0.1 µm and with a lithographic ink in order to print.

Dampening solutions suitable for use in the present invention are preferably aqueous solutions comprising water-soluble organic solvents. Examples of such water-soluble organic solvents include alcohols, polyhydric alcohols, ethers, polyglycols and esters.

Examples of the alcohols include n-butyl alcohol, n-amyl alcohol, n-hexyl alcohol, 2-methylpentanol-1, secondary hexyl alcohol, 2-ethylbutyl alcohol, secondary heptyl alcohol, heptanol-3,2-ethylhexyl alcohol and benzyl alcohol.

Examples of the polyhydric alcohols include ethylene glycol, hexylene glycol, octylene glycol, diethylene glycol and glycerol. Examples of the ethers include ethylene glycol monoethyl ether, ethylene glycol mono-n-hexyl ether, ethylene glycol monophenyl ether, ethylene glycol mono-2-ethylbutyl ether, diethylene glycol monoethyl ether and diethylene glycol mono-n-hexyl ether.

Examples of the esters include diethylene glycol monoethyl ether acetate and diethylene glycol monobutyl ether acetate.

Examples of polyglycols include polyethyleneglycols having an average molecular weight of 400 to 2000, polypropylene glycols having an average molecular weight of 400 to 2000, and block copolymers of ethylene glycol and propylene glycol.

The water-soluble organic solvents are incorporated in the dampening solutions to depress the dynamic surface tension. However, it is preferred to use as little of the organic solvents as possible. With this goal in mind, it was also discovered that dynamic tension can be greatly lowered by the addition of organic solvents having low solubilities in water. As a result, small amounts of such solvents can be effectively used. These type of organic solvents have a solubility of about 0.5 to 80 % by weight, preferably 0.5 to 10 % by weight, in water at 20°C.

The dynamic surface tension of the dampening solution is lowered by adding said organic solvents, but should not be less than 25 dyne/cm, because the dampening solution is an aqueous solution. Good printing effects can be obtained when the dynamic surface tension ranges from 25 to 50 dyne/cm at 15 °c at most 1.10.⁻¹ second after a surface of said solution is formed on the surface of a printing plate, measured with the NOW-INSTANT WILHELMY DYNAMIC SURFACE TENSION ACCESSORY manufactured by Cahn Co, U.S.A..

The dampening solutions used in the present invention may contain from about 0.05 to 1,5 % by weight of these water-soluble organic solvents.

It is preferred that the dampening solutions have a pH of 3 to 6. Usually, mineral acids, organic acids or inorganic salts are added to adjust the pH to from 3 to 6. The amount of these compounds to be added are preferably 0.00001 to 0.5 % by weight.

Examples of the mineral acids include nitric acid, sulfuric acid and phosphoric acid. Examples of organic acids include citric acid, acetic acid and organic phosphonic acids. These mineral acids, organic acids or inorganic salts may be used either alone or in a combination of two or more of them.

Generally, surfactants are added to the dampening solution to increase the emulsification ratio in ink. The contents of these surfactants should not be higher than 1 % by weight, preferably 0.0001 to 0.3 % by weight when foaming is taken into consideration.

Preferably, the dampening solution used in the present invention also comprises thickening agents. Examples of thickening agents which can be used in the present invention include water-soluble cellulose derivatives, alginate and derivatives, gum, water-soluble modifications of starch, and water-soluble high-molecular homopolymers and copolymers. These compounds may be used either alone or as a mixture of two or more of them.

The concentration varies depending on the type of the thickening agents, but is preferably about 0.00005 to 1 % by weight based on the amount of the dampening solution composition.

In general, the dampening solution used in the present invention comprises a (combination of) preservative(s), so that the composition is effective for controlling various kinds of mold, bacteria and yeast.

In addition to the above-described components, the dampening solution of the present invention may contain chelate compounds preferably in an amount of 0.00001 to 0.3 % by weight based on the amount of the dampening solution and corrosion inhibitors preferably in an amount of 0.000001 to 0.5 % by weight.

The dampening solution as described above is ready for use as such. In a more preferred embodiment the dampening solution is concentrated and the concentrate is diluted when used. The concentrated dampening water composition of the present invention can be obtained by dissolving the foregoing components in a 10 to a 100 times higher concentration than mentioned above in pure water to give an aqueous solution. The concentrated composition is diluted with sufficient tap water or well water prior to the practical use in order to give a dampening solution as described above which is suitable for use.

The dampening solution can be used alone or in combination with water-soluble organic solvents e.g. isopropanol or substitutes therefore.

Any of the conventional lithographic inks can be used in the present invention. Examples of the lithographic inks include general process color ink, offset printing ink, multi-color ink, gold and silver ink, UV ink, ink for synthetic paper, fluoresent ink and metallic ink.

The dampening system suitable for use in the present invention may be an integrated system, whereby the dampening solution and the ink are brought into contact with each other before applying them to the lithographic plate e.g. by feeding the dampening solution to inked rollers. Preferably, the dampening system used in the present invention is a separated system, whereby the dampening solution is fed to the lithographic plate using rubber rollers independent of the inked rollers. Also preferred dampening systems used in the present invention are hybrid systems, whereby some dampening solution is brought into contact with the ink before applying the mixture to the lithographic plate and some dampening solution is fed to the lithographic plate using rubber rollers independent of the inked rollers.

As printing press any lithographic printing press can be used.

Printing can be effected on any ink-receptive element i.a. depending on the required printing effect. In general, paper is used but even cardboard can be used.

The following examples illustrate the present invention without limiting it thereto. All percentages are by weight unless stated otherwise.

### EXAMPLE 1 ( Comparative example)

### Preparation of the silver halide emulsion coating solution.

A silver chlorobromide emulsion composed of 98 mole% of chloride, 1.7 mole% of bromide and 0.3 mole% of iodide was prepared by the double jet precipitation method. The average silver halide grain size was 0.4µm (diameter of a sphere with equivalent volume) and contained Rhodium ions as internal dopant. The emulsion was orthochromatically sensitized and stabilized by 1-phenyl-5-mercapto-tetrazole.
A base layer coating solution was prepared having the following composition:

| | |
|---|---|
| gelatin | 5.5% |
| carbon black | 0.76% |
| silica particles (5µm) | 1.6% |

### Preparation of the imaging elements.

The emulsion coating solution and base layer coating solution were simultaneously coated by means of the cascade coating technique to a polyethylene terephthalate support provided with a pack of two backing layers such that the base layer coating was coated directly to the side of the support opposite to the side containing said backing layers. The emulsion layer was coated such that the silver halide coverage expressed as AgNO₃ was 1.5g/m² and the gelatin content was 1.5g/m². The emulsion layer further contained 0.15g/m² of 1-phenyl-4,4'-dimethyl-3-pyrazolidone and 0.25g/m² of hydroquinone. The base layer was coated such that the amount of gelatin in the coated layer was 3g/m².

The layer nearest to the support of the backing layer pack contained 0.3 g/m² of gelatin and 0.5 g/m² of the antistatic agent co(tetraallyloxyethane / methacrylate / acrylic acid-K-salt) polymer. The second backing layer contained 4 g/m² of gelatin, 0.15 g/m² of a matting agent consisting of transparent spherical polymeric beads of 3 micron average diameter according to EP-A- 0080225, 0.05 g/m² of hardening agent triacrylformal and 0.021 g/m² of wetting agent F₁₅C₇-COONH₄.

The thus obtained element was dried and subjected to a temperature of 40°C for 5 days and then the emulsion layer was overcoated with a layer containing PdS as physical development nuclei, hydroquinone at 0.4g/m² and formaldehyde at 100mg/m².
The following processing solutions were prepared :

| Activator | K | L |
|---|---|---|
| potassium hydroxide (g) | 30 | 30 |
| sodium sulphite anh. (g) | 35 | 35 |
| potassium thiocyanate (g) | 20 | 0 |
| compound 3 of table 1 (mg) | 0 | 1000 |
| 2-Aminoethyl-aminoethanol (g) | 10 | 10 |
| 2-mercapto-5-n.heptyl-oxa-3,4-diazole (mg) | 300 | 300 |
| potassium bromide (mg) | 280 | 280 |
| water to make | 1 l | 1 l |

| Neutralization solution | |
|---|---|
| citric acid | 10 g |
| sodium citrate | 35 g |
| sodium sulphite anh. | 5 g |
| phenol | 50 mg |
| water to make | 1 l |

Two imaging elements as described above were image-wise exposed and processed with one of the above described activators, subsequently neutralized at 25 °C with the neutralization solution described above and dried.

The printing plates thus prepared were mounted beside each other on the same offset printing machine (HEIDELBERG GTO-46) and were printed under identical conditions. Commercial SWEGO-SOFT 8150/36, marketed by Schwegman Gmbh & Co., Bonn, Germany and containing no silica or alumina of any kind was used at a 3 % concentration in an aqueous solution containing 10 % isopropanol as dampening solution in accordance with the invention. Commercial SWEGO-SOFT 8150/36 whereon was added 28 g/l colloidal silica was used at a 3 % concentration in an aqueous solution containing 10 % isopropanol as comparative dampening solution. K+E 125 ink, marketed by Kast+Ehinger, A.G., Germany, and a compressible rubber blanket was used. The plates were printed to provide more than 25,000 copies.

The results are summed up in table 3.

The lithographic properties - printing endurance and staining-were evaluated as follows :
a) printing endurance : number of printed copies before disappearance of ink in the ink accepting areas begins to occur :
b) staining : the number of copies that can be printed before background stain shows up.

**Table 3**

| Printing run | Activator | Dampening solution | Staining | Printing endurance |
|---|---|---|---|---|
| I (Comp.) | K | SWEGO-SOFT | 100 | 20,000 |
| II (Inv.) | L | SWEGO-SOFT | > 25,000 | > 25,000 |
| III (Comp.) | L | SWEGO-SOFT + SiO₂ | > 25,000 | 10,000 |

As can be seen from table 3 a method for lithographic printing according to the present invention using a lithographic printing plate obtained according to the DTR-process in the presence of compound 3 of table 1 and a dampening solution containing no colloidal siliciumoxide shows clearly improved printing properties i.e. no ink acceptance in the non-printing areas even by a high number of copies and a high printing endurance.

### EXAMPLE 2

Printing plates were prepared as described in example 1 but by processing solely with activator L.

The printing plates thus prepared were mounted on an AB DICK 360 , marketed by AB Dick Co, USA, equipped with a Varn dampening system, marketed by Varn Products Co Ltd, Manchester, UK. As dampening solutions were used either a mixture of AQUA AYDE 7022 at a 4 % concentration and AQUA TAME 7035E at a 3 % concentration, both of Anchor/Lithemko Inc., Florida, USA or KOMPAC II-VSP-401 of Varn Products Co Ltd, Manchester, UK. and neither of them containing silica or alumina of any kind. The ink used was ABD 1020, marketed by AB Dick Co, USA.

All printing runs showed a printing endurance of more than 25,000 copies all of which were free of stain.

## Claims

1. A method for lithographic printing comprising the following steps:
- preparing a lithographic printing plate according to the silver salt diffusion transfer process by (1) image-wise exposing an imaging element comprising on a support a photosensitive layer comprising a silver halide emulsion and an image receiving layer containing physical development nuclei and (2) developing said imaging element in the presence of developing agent(s) and silver halide solvent(s) using an alkaline processing liquid,
- mounting said lithographic printing plate to a lithographic printing press, and
- printing while supplying to said lithographic printing plate a dampening solution and a printing ink
characterized in that (a) said development of the exposed imaging element is carried out in the presence of a meso-ionic compound and (b) the dampening solution is substantially free of a transparent pigment with an average grain diameter of less than 0.1 µm.

2. A method according to claim 1 wherein said meso-ionic compound corresponds to the following formula: 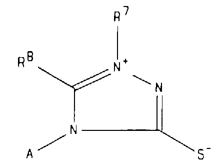 wherein R⁷ and R⁸ each independently represents an alkyl group, alkenyl group, cycloalkyl group, aralkyl group, aryl group or heterocyclic group, which groups can be substituted; A represents an alkyl group, alkenyl group, cycloalkyl group, aralkyl group, aryl group, heterocyclic group, which groups can be substituted or -NR⁹R¹⁰ wherein R⁹ and R¹⁰ each independently represents hydrogen, an alkyl group or aryl group, which groups can be substituted, or R⁷ and R⁸ or R⁸ and A or R⁹ and R¹⁰ represent the necessary atoms to form a 5- or 6-membered ring.

3. A method according to claim 1 wherein said meso-ionic compound is present in said alkaline processing liquid which further comprises a thioether and/or an alkanolamine.

4. A method according claim 1 wherein said dampening solution is an aqueous solution comprising a water-soluble organic solvent.

## Patentansprüche

1. Lithografisches Druckverfahren bereit, das die nachstehenden Stufen umfasst :
- die Herstellung einer lithografischen Druckplatte nach dem Silbersalz-Diffusionsübertragungsverfahren durch (1) bildmäßige Belichtung eines Bild erzeugenden Elements, das auf einem Träger eine strahlungsempfindliche Schicht, die eine Silberhalogenidemulsion enthält, und eine physikalische Entwicklungskeime enthaltende Bildempfangsschicht umfasst, und (2) die Entwicklung dieses Bild erzeugenden Elements in Gegenwart einer oder mehrerer Entwicklersubstanzen und eines oder mehrerer Silberhalogenid-Lösungsmittel unter Verwendung einer alkalischen Verarbeitungsflüssigkeit,
- das Einspannen der lithografischen Druckplatte in einer lithografischen Druckpresse, und
- den Druckvorgang, wobei auf die lithografische Druckplatte ein Feuchtwasser und eine Druckfarbe aufgetragen werden,
dadurch gekennzeichnet, dass (a) diese Entwicklung des belichteten Bild erzeugenden Elements in Gegenwart einer meso-ionischen Verbindung durchgeführt wird und (b) das Feuchtwasser im wesentlichen frei ist von einem transparenten Pigment mit einem durchschnittlichen Korndurchmesser kleiner als 0,1 µm.

2. Verfahren nach Anspruch 1, dadurch gekennzeichnet, dass diese meso-ionische Verbindung der folgenden Formel entspricht : 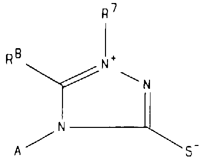 in der R⁷ und R⁸ jeweils unabhängig voneinander eine gegebenenfalls substituierte Alkylgruppe, Alkenylgruppe, Cycloalkylgruppe, Aralkylgruppe, Arylgruppe oder heterocyclische Gruppe bedeuten; A eine gegebenenfalls substituierte Alkylgruppe, Alkenylgruppe, Cycloalkylgruppe, Aralkylgruppe, Arylgruppe, heterocyclische Gruppe oder -NR⁹R¹⁰ bedeutet, in der R⁹ und R¹⁰ jeweils unabhängig voneinander ein Wasserstoffatom, eine gegebenenfalls substituierte Alkyl- oder Arylgruppe bedeuten, oder in der R⁷ und R⁸ oder R⁸ und A oder R⁹ und R¹⁰ die zur Bildung eines 5- oder 6-gliedrigen Rings notwendigen Atome bedeuten.

3. Verfahren nach Anspruch 1, dadurch gekennzeichnet, dass diese meso-ionische Verbindung in der alkalischen Verarbeitungsflüssigkeit enthalten ist, die weiterhin ein Thioether und/oder ein Alkanolamin enthält.

4. Verfahren nach Anspruch 1, dadurch gekennzeichnet, dass das Feuchtwasser eine wässrige Lösung ist, die ein wasserlösliches organisches Lösungsmittel enthält.

## Revendications

1. Procédé pour l'impression lithographique comprenant les étapes ci-après consistant à:
- préparer un cliché d'impression lithographique conformément au procédé de transfert de sels d'argent par diffusion (1) en exposant en forme d'image un élément de formation d'image comprenant, sur un support, une couche photosensible comprenant une émulsion à l'halogénure d'argent et une couche de réception d'image contenant des germes de développement physique, et (2) en développant ledit élément de formation d'image en présence d'un ou de plusieurs agents développateurs et d'un ou de plusieurs solvants pour l'halogénure d'argent en utilisant un liquide de traitement de type alcalin,
- monter ledit cliché d'impression lithographique dans une presse d'impression lithographique, et
- imprimer, tout en acheminant audit cliché d'impression lithographique une solution de mouillage et une encre d'impression,
caractérisé en ce que (a) ledit développement de l'élément de formation d'image à l'état exposé est réalisé en présence d'un composé méso-ionique et (b) la solution de mouillage est essentiellement exempte d'un pigment transparent dont le diamètre de grains moyen est inférieur à 0,1 µm.

2. Procédé selon la revendication 1, dans lequel ledit composé méso-ionique répond à la formule ci-après: 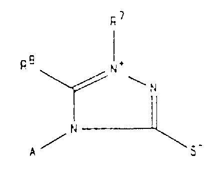 dans laquelle R⁷ et R⁸ représentent chacun, indépendamment l'un de l'autre, un groupe alkyle, un groupe alcényle, un groupe cycloalkyle, un groupe aralkyle, un groupe aryle ou un groupe hétérocyclique, lesdits groupes pouvant être substitués; A représente un groupe alkyle, un groupe alcényle, un groupe cycloalkyle, un groupe aralkyle, un groupe aryle, un groupe hétérocyclique, lesdits groupes pouvant être substitués, ou encore un groupe -NR⁹R¹⁰ où R⁹ et R¹⁰ représentent chacun, indépendamment l'un de l'autre, un atome d'hydrogène, un groupe alkyle ou un groupe aryle, lesdits groupes pouvant être substitués, ou bien R⁷ et R⁸ ou R⁸ et A ou encore R⁹ et R¹⁰ représentent les atomes nécessaires pour former un noyau penta- ou hexagonal.

3. Procédé selon la revendication 1, dans lequel ledit composé méso-ionique est présent dans ledit liquide de traitement de type alcalin qui comprend en outre un thioéther et/ou une alcanolamine.

4. Procédé selon la revendication 1, dans lequel ladite solution de mouillage est une solution aqueuse comprenant un solvant organique hydrosoluble.
